# EUROPÄISCHE PATENTANMELDUNG

(11) **EP 1 137 073 A1**
(43) Veröffentlichungstag der Anmeldung: **26.09.2001**
(21) Anmeldenummer: 00106474.0
(22) Anmeldetag: 24.03.2000
(51) Int. Cl.: H01L 29/737, H01L 29/417, H01L 21/331

(54) **Heterobipolar-Transistor mit T-förmigem Emitteranschlusskontakt und Herstellungsverfahren dafür**

(71) Anmelder: Infineon Technologies AG, 81669 München (DE)
(72) Erfinder: Kraus, Stefan, Dr.-Ing., 82065 Baierbrunn (DE)
(74) Vertreter: Ginzel, Christian

(57) **Zusammenfassung**

Bei der Herstellung wird in eine auf der Transistor-Schichtenfolge abgeschiedene Isolationsschicht (11) eine Emitteröffnung geformt, in die der Emitteranschlußkontakt (12, 13) mit einer definierten Bedeckung des Öffnungsrandes abgeschieden wird. Anschließend wird unter Verwendung des Emitteranschlußkontaktes (12, 13) als Ätzmaske eine die mesaförmige Struktur geätzt. Die zurückbleibende elektrisch isolierende Zone (11a) wirkt als Apertur für den elektrischen Strom, der somit auf einen zentralen Bereich der Emitterschicht (5) und einer Emitterkontaktschicht (6a, 6b) beschränkt wird.

## Beschreibung

Die Erfindung betrifft ein Verfahren zur Herstellung eines Heterobipolar-Transistors nach den Merkmalen des Patentanspruchs 1 und einen Heterobipolar-Transistor nach dem Oberbegriff des Patentanspruchs 9.

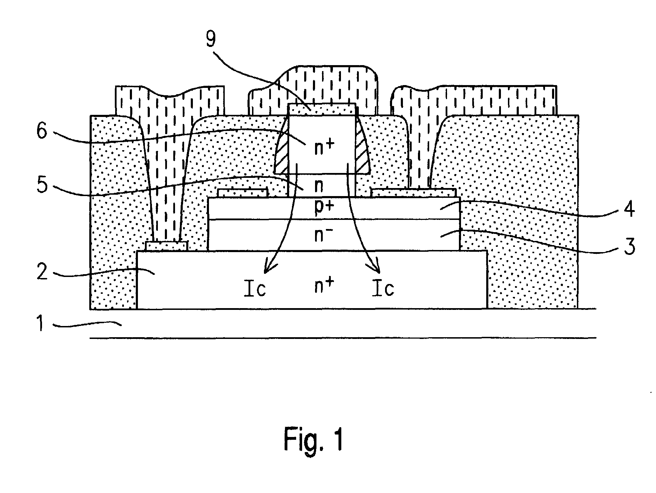

Die Erfindung liegt somit auf dem technischen Gebiet der Herstellungsverfahren für Halbleiterbauelemente, die aus einer Anzahl von epitaktisch aufgewachsenen Halbleiterschichten bestehen. Bei Heterobipolar-Transistoren sind seit einiger Zeit Bauelemente auf der Basis des Materialsystems InGaP/GaAs bekannt, die gegenüber denjenigen Bauelementen auf der Basis des Materialsystems AlGaAs/GaAs eine Reihe von Vorteilen aufweisen. InGaP/GaAs-Heterobipolar-Transistoren bestehen beispielsweise aus einem semi-isolierenden GaAs-Substrat 1, einer n⁺-dotierten GaAs-Subkollektorschicht 2, einer n⁻-dotierten GaAs-Kollektorschicht 3, einer p⁺-dotierten GaAs-Basisschicht 4, einer n-dotierten InGaP-Emitterschicht 5 und einer n⁺-dotierten InGaAs-Deckschicht 6 (Fig. 1). Ein derartiges Bauelement wird beispielsweise in der Publikation von M. Hafizi in "IEEE Transactions on Electron Devices", Vol. 45, No. 9, September 1998, Seiten 1862-1868, beschrieben. Durch projektionslithographische Resiststrukturierung und mehrere Ätzschritte wird die aus der Emitterschicht 5 und der Deckschicht 6 bestehende mesaförmige Struktur gewonnen.

Der Hauptnachteil dieser Bauelementstruktur liegt jedoch darin, daß der Emitter-Kollektor-Strom I_{c} (s. Pfeile) von dem Emitteranschlußkontakt 9 durch die Deckschicht 6 zum Teil nahe an deren Seitenwänden zu der Kollektorschicht 3 und der Subkollektorschicht 2 fließt. Diese Seitenwände sind jedoch durch den Ätzvorgang und die dabei ablaufenden Unterätzungen mehr oder weniger stark in Mitleidenschaft gezogen worden, so daß eine hohe Anzahl von Defekten an der Seitenwand und in ihrer unmittelbaren Nähe resultiert. Diese Kristalldefekte führen in verstärktem Maß zu Oberflächenrekombinationen, wodurch die Effizienz des Bauelements beeinträchtigt wird.

Es ist demgemäß Aufgabe der vorliegenden Erfindung, einen Heterobipolar-Transistor und ein praktikables und vorteilhaftes Herstellungsverfahren für einen Heterobipolar-Transistor anzugeben, wobei eine den Emitteranschlußkontakt enthaltende mesaförmige Struktur geformt wird und eine Beeinträchtigung der Funktion des Bauelements durch den Einfluß von Seitenwänden der Emitterschicht und/oder einer gegebenenfalls vorhandenen Emitterkontaktschicht vermieden wird.

Diese Aufgabe wird durch die Merkmale des Patentanspruchs 1 und die kennzeichnenden Merkmale des Patentanspruchs 9 gelöst.

Demgemäß beschreibt die vorliegende Erfindung ein Verfahren zur Herstellung eines Heterobipolar-Transistors, mit den Verfahrensschritten:
A.) Aufwachsen einer Folge von Epitaxieschichten enthaltend eine Kollektorschicht, eine Basisschicht und eine Emitterschicht auf ein Halbleitersubstrat;
B.) Aufwachsen einer Isolationsschicht und Formen einer bis zu der Emitterschicht reichenden Emitteröffnung in die Isolationsschicht;
C.) Abscheiden eines Emitteranschlußkontaktes in die Emitteröffnung derart, daß dieser sich mindestens entlang einem Umfangsabschnitt der Emitteröffnung über den Öffnungsrand hinaus auf die Oberfläche der Isolationsschicht erstreckt;
D.) Erzeugen einer mesaförmigen Struktur durch Entfernen der Isolationsschicht und mindestens teilweises Entfernen der Emitterschicht außerhalb des Emitteranschlußkontaktes durch einen oder mehrere Ätzschritte mit dem Emitteranschlußkontakt als Ätzmaske;
E.) Abscheiden mindestens eines Basisanschlußkontaktes auf einem Abschnitt außerhalb der mesaförmigen Struktur;
F.) mindestens auf einem Abschnitt Entfernen von gegebenenfalls einem verbliebenen Teil der Emitterschicht und der Basisschicht außerhalb der mesaförmigen Struktur;
G.) Abscheiden eines Kollektoranschlußkontaktes auf dem nicht mehr von der Basisschicht bedeckten Abschnitt.

Die vorliegende Erfindung bezieht sich somit ebenso auf einen Heterobipolar-Transistor, mit
- einer Folge von Epitaxieschichten enthaltend eine Kollektorschicht, eine Basisschicht und eine Emitterschicht und einen Emitteranschlußkontakt, wobei
- die Emitterschicht und der Emitteranschlußkontakt Teil einer mesaförmigen Struktur sind, und wobei
- zwischen dem Emitteranschlußkontakt und der Emitterschicht eine mindestens entlang einem Umfangsabschnitt der mesaförmig Struktur verlaufende elektrisch isolierende Zone geformt ist.

Die im Verlaufe des Herstellungsprozesses aus der Isolationsschicht geformte elektrisch isolierende Zone bildet eine Apertur zwischen dem Emitteranschlußkontakt und der Emitterschicht oder gegebenenfalls einer zusätzlichen Emitterkontakt- oder -deckschicht, so daß der elektrische Strom auf einen zentralen Bereich der Emitterschicht und/oder der Emitterkontaktschicht begrenzt wird und von den Seitenwänden dieser Schichten ferngehalten wird. Der Emitteranschlußkontakt kann dabei derart geformt sein, daß er eine T-förmige Struktur aufweist, deren oberer Teil auf der der Emitterschicht abgewandten Seite der elektrisch isolierenden Zone liegt und deren unterer Teil innerhalb der ringförmig verlaufenden elektrisch isolierenden Zone zu liegen kommt.

Der Emitter ist zumeist ein langgestrecktes Gebiet, beispielsweise ein Gebiet mit einer Fläche von 3 x 30 *µ*m² wie in dem weiter unten beschriebenen Ausführungsbeispiel. In diesem Fall ist es ausreichend, wenn während der Herstellung entlang den Längsseiten der Emitteröffnung die Randbedeckung bei der Abscheidung des Emitteranschlußkontaktes vorgenommen wird, so daß die Isolationszone auch nur an den Längsseiten ausgebildet wird.

Die Isolationsschicht im Verfahrensschritt B. kann beispielsweise eine SiN-Schicht sein.

Der Emitteranschlußkontakt kann aus einer einzelnen Kontaktschicht bestehen oder in an sich bekannter Weise durch zwei Kontaktschichten gebildet sein. Dabei kann eine erste Kontaktschicht, vorzugsweise bestehend aus einer WSi-Schicht oder einer W/WSi-Schichtenfolge, und einer zweiten Kontaktschicht, vorzugsweise bestehend aus einer Ti/Pt/Au-Schichtenfolge gebildet werden. Dabei kann im Verfahrensschritt C. zuerst die erste Kontaktschicht ganzflächig abgeschieden werden und anschließend die zweite Kontaktschicht vorzugsweise mittels der Image-Reversal-Phototechnik in die Emitteröffnung und den Randbereich abgeschieden werden und anschließend die erste Kontaktschicht außerhalb der zweiten Kontaktschicht entfernt werden, wobei die zweite Kontaktschicht als Maske verwendet wird. Es kann dann auch das Entfernen der ersten Kontaktschicht im Verfahrensschritt C. und das Entfernen der Isolationsschicht im Verfahrensschritt D. unmittelbar aufeinanderfolgend in einem einzelnen Ätzschritt durchgeführt werden. Nach dem Entfernen der Isolationsschicht wird gegebenenfalls im Verfahrensschritt D. zuerst die Emitterkontaktschicht entfernt, worauf dann die Emitterschicht im Verfahrensschritt D. entfernt wird.

Im Verfahrensschritt E. können in an sich bekannter Weise zwei Basisanschlußkontakte symmetrisch beidseits der mesaförmigen Struktur abgeschieden werden.

Im Verfahrensschritt F. wird vorzugsweise eine zweite mesaförmige Struktur geformt, indem die erste mesaförmige Struktur und die Basisanschlußkontakte (geschützt mit SiN) als Ätzmaske verwendet werden. Dabei wird der Ätzschritt bis zu der Kollektorschicht oder der darunterliegenden Subkollektorschicht durchgeführt.

Alternativ dazu kann jedoch im Verfahrensschritt F. auch eine Kontaktlochätzung bis zu der Kollektorschicht oder der Subkollektorschicht durchgeführt werden.

In jedem Fall wird anschließend im Verfahrensschritt G. mindestens ein Kollektoranschlußkontakt auf einem nicht mehr von der Basisschicht bedeckten Abschnitt abgeschieden.

Im folgenden wird das erfindungsgemäße Verfahren anhand eines einzigen Ausführungsbeispiels bezugnehmend auf die Zeichnungen näher erläutert. Es zeigen:
- Fig. 1: eine Querschittsdarstellung eines Heterobipolar-Transistors nach dem Stand der Technik;
- Fig. 2A-N: die einzelnen Herstellungsschritte eines Ausführungsbeispiels des erfindungsgemäßen Verfahrens zur Herstellung eines Heterobipolar-Transistors.

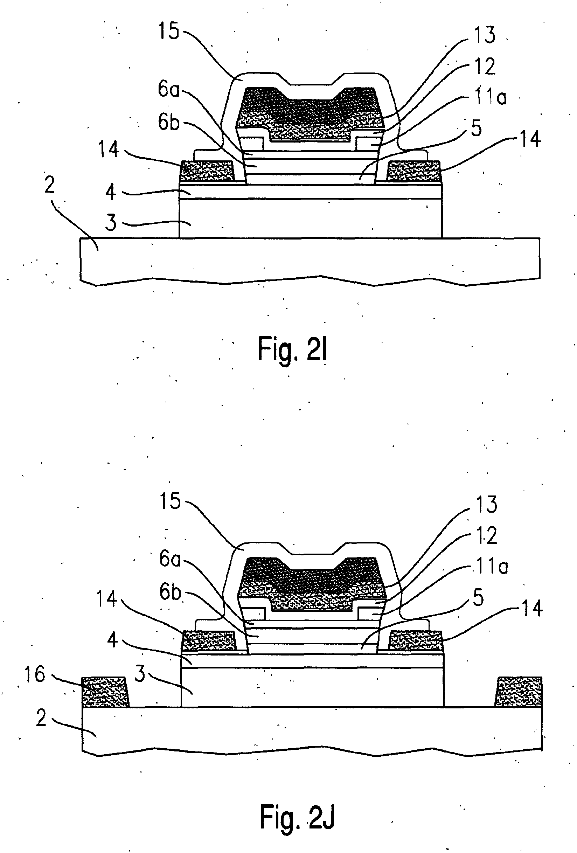

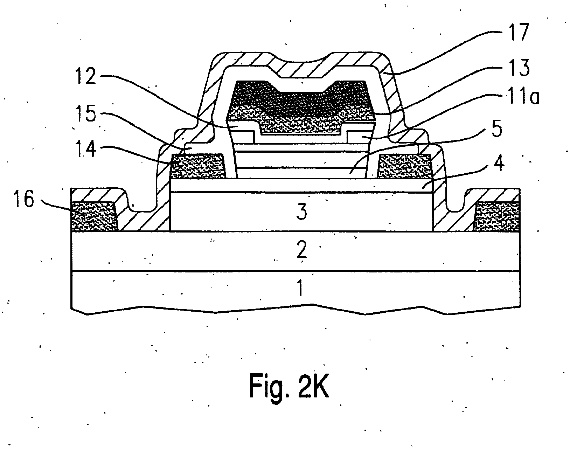

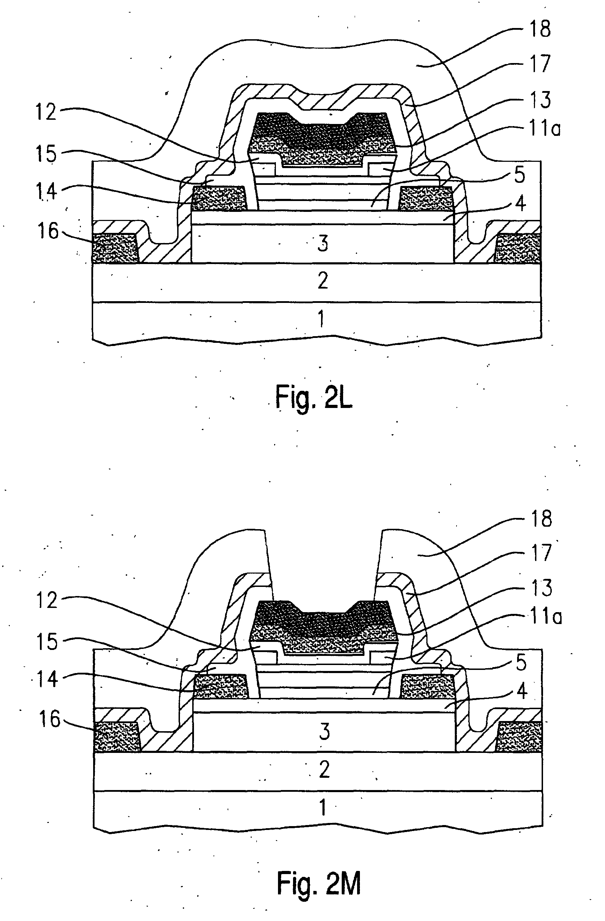

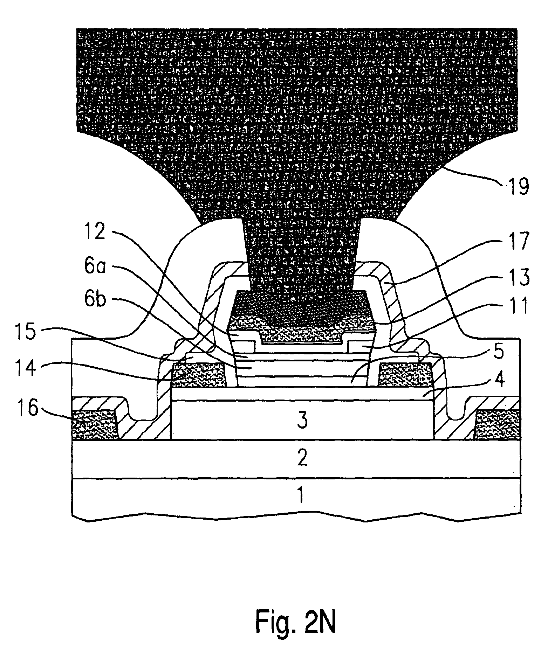

In dem Ausführungsbeispiel wird ein InGaP/GaAs-Heterobipolar-Transistor hergestellt. Der Übersichtlichkeit der einzelnen Zeichnungen halber wird zumeist nur ein Teil des Substrates dargestellt, um die auf der Oberfläche durchgeführten Prozeßschritte zu verdeutlichen. Das gesamte fertiggestellte Bauelement ist in der Fig. 2N dargestellt. Diese zeigt einen Halbleiter-Heterobipolar-Transistor in einer Querschnittsdarstellung durch die den Transistor bildenden mesaförmigen Strukturen.

Ausgehend von der Darstellung der Fig. 2N wird auf ein semiisolierendes GaAs-Substrat 1 zuerst eine n⁺-GaAs-Subkollektorschicht 2 aufgewachsen. Anschließend wird auf dieser eine schwach n-dotierte GaAs-Kollektorschicht 3 aufgewachsen. Auf dieser wird dann eine p⁺-dotierte GaAs-Basisschicht 4 abgeschieden und auf diese wird eine n-dotierte InGaP-Emitterschicht 5 aufgebracht. Auf die Emitterschicht 5 wird schließlich noch eine Emitterdeck- oder -kontaktschicht abgeschieden, die beispielsweise eine Doppelschicht aus einer oberen n⁺-dotierten InGaAs-Deckschicht 6a und einer unteren n⁺-dotierten GaAs-Deckschicht 6b sein kann. Die einzelnen Schichten können beispielsweise durch MBE oder durch MOCVD oder ein kombiniertes Verfahren aufgewachsen werden.

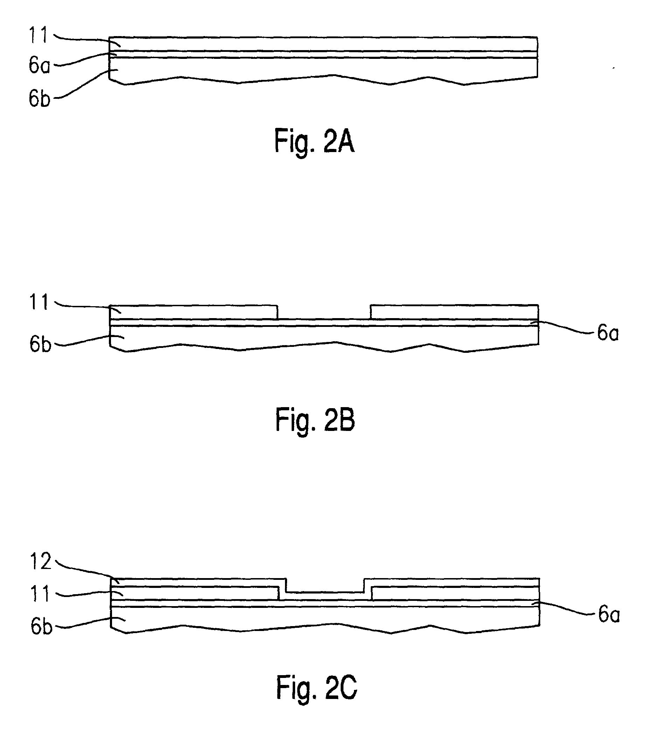

Gemäß Fig. 2A wird auf der oberen Deckschicht 6a zuerst eine Isolationsschicht 11, beispielsweise eine SiN-Schicht, aufgebracht. Die Dicke dieser Isolationsschicht beträgt beispielsweise 300 nm.

Mittels Photolithographie, Resist-Strukturierung und anschließender trockenchemischer Ätzung wird anschließend gemäß Fig. 2B eine Emitteröffnung in die Isolationsschicht 11 geformt, durch die die Größe des Emitters festgelegt wird. Die Größe der Emitteröffnung beträgt dementsprechend typischerweise 3 x 30 *µ*m². In der Emitteröffnung wird die Isolationsschicht 11 vollständig entfernt, so daß am Boden der Emitteröffnung die Oberfläche der oberen Deckschicht 6a freiliegt.

Nach einer Reinigung der Oberfläche wird anschließend gemäß der Fig. 2C in einem Sputter-Prozeß eine erste elektrische Kontaktschicht 12 abgeschieden. Diese Kontaktschicht 12 wird im vorliegenden Fall als Schichtfolge W/WSi mit einer Gesamtdicke von 80 nm abgeschieden. Durch den Sputter-Prozeß erfolgt eine etwa gleichmäßige Belegung der Oberfläche mit der ersten Kontaktschicht 12.

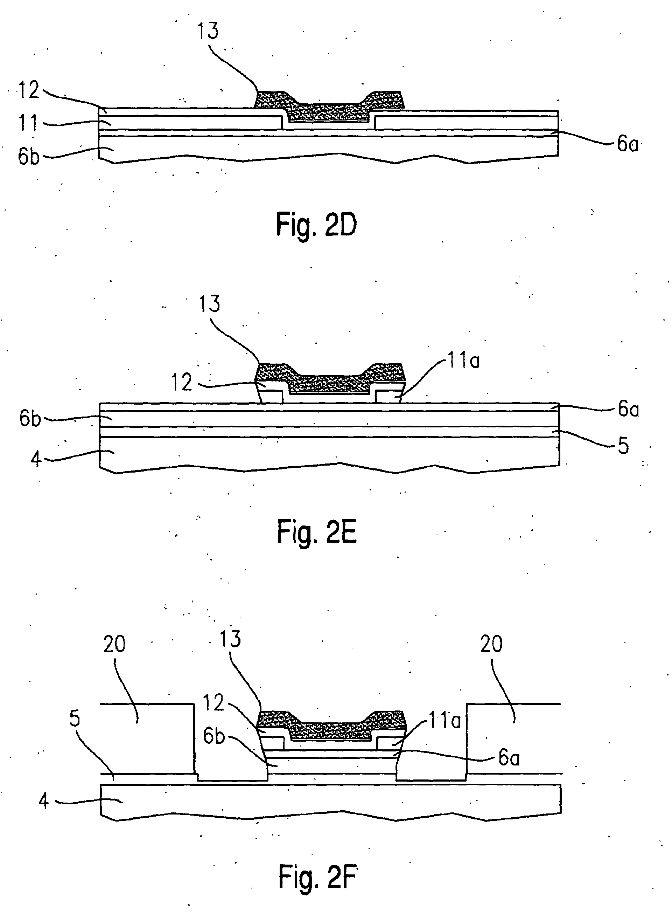

Anschließend wird gemäß der Fig. 2D mittels der sogenannten Image-Reversal-Phototechnik eine zweite elektrische Kontaktschicht 13 mit einem Überlapp von etwa 0,5 *µ*m auf beiden Längsseiten der Emitteröffnung in die mit der ersten elektrischen Kontaktschicht 12 bedeckte Emitteröffnung aufgebracht. Als zweite elektrische Kontaktschicht 13 wird in an sich bekannter Weise eine Schichtenfolge Ti/Pt/Au abgeschieden.

Gemäß der Fig. 2E kann anschließend in einem einzigen Prozeß selbstjustierend mit Hilfe der zweiten elektrischen Kontaktschicht 13 als Maske trockenchemisch die erste elektrische Kontaktschicht 12 (W/WSi) und die Isolationsschicht 11 (SiN) strukturiert werden, wobei die InGaAs-Halbleiteroberfläche der oberen Deckschicht 6a als Ätzstopp fungieren kann. Durch Optimierung der Prozeßparameter (isotrope/anisotrope Ätzung, Überätzung) kann die Unterätzung der Emitter-Metallisierung gezielt beeinflußt werden. Als Ergebnis dieses Ätzschrittes bleibt eine elektrisch isolierende Zone 11a zurück. Auf dieser ist der aus den Kontaktschichten 12 und 13 gebildete Emitteranschlußkontakt als T-förmige Struktur geformt.

Anschließend werden zunächst gemäß der Fig. 2F die InGaAs- und GaAs-Deckschichten 6a und 6b des Heterobipolar-Transistors durch eine selbstjustierende Strukturierung abgeätzt. Dazu kann beispielsweise eine inductive coupled plasma-Anlage (ICP) verwendet werden. Sie bietet den Vorteil, daß durch Einstellung der HF-Leistung an der Bottom-Elektrode exakt zwischen anisotroper (hoher Bias) und isotroper (kleiner Bias) Ätzung gewählt werden kann. In einem Zwei-Stufenprozeß werden zuerst die In-haltigen Schichten (InGaAs) mit hoher Leistung (hoher physikalischer Anteil) geätzt und sofort anschließend werden dann die In-freien Schichten (GaAs) mit einer kleinen Leistung geätzt. Mittels Detektion des emittierten Plasma-Lichtes kann der Endpunkt der InGaAs- und der GaAs-Ätzung bestimmt werden und die Ätzschritte können reproduzierbar gestoppt werden. Die InGaP-Emitterschicht 5 dient dabei zunächst als Ätzstoppschicht, die bei dem gewählten Ätzparameter eine sehr geringe Ätzrate aufweist. Durch geeignete Wahl der Leistung und der Überätzzeit kann die Unterätzung der GaAs-Schicht gezielt beeinflußt werden.

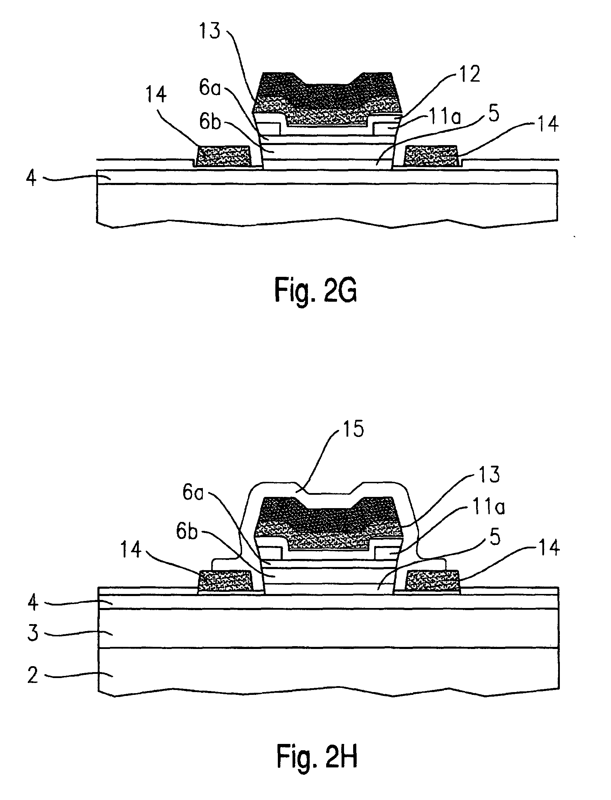

Anschließend wird dann gemäß Fig. 2F unter Zuhilfenahme einer strukturierten Photoresist-Schicht 20 die Emitterschicht 5 auf einem Abschnitt teilweise abgetragen, auf dem Basisanschlußkontakte 14 (s. Fig. 2G) geformt werden sollen. Bei normaler Dotierung stellt eine Restdicke von 30-50 nm keine leitende Verbindung mehr dar, so daß keine elektrische Verbindung zwischen den Basisanschlußkontakten und dem Emitter hergestellt wird. Das Abtragen kann beispielsweise durch einen Ar-Sputter-Schritt durchgeführt werden, worauf dann im Verfahrensschritt gemäß Fig. 2G das selbstjustierende Aufdampfen der Basisanschlußkontakte 14 erfolgt. In diesem Fall wird für die Basisanschlußkontakte 14 die Schichtfolge Pt/Ti/Pt/Au gewählt, wobei Platin als erste Metallisierungsschicht notwendig ist, um durch die verbleibende InGaP-Schicht einen flachen Kontakt zur Basisschicht 4 zu bilden. Alternativ dazu kann die Emitterschicht durch den Sputter-Schritt auch vollständig abgetragen werden oder bereits durch die vorangegangene Ätzung vollständig entfernt werden.

Die in dem Verfahrensschritt gemäß der Fig. 2G gebildete, sogenannte Basis-Gabel, also der Abstand zwischen den Basisanschlußkontakten 14 hat eine typische Breite von 2 *µ*m. Durch die Höhe der Basis-Metallisierung, die Höhe der SiN-Passivierung und die Unterätzung des Emitters wird der Abstand zwischen Emitter und Basis-Metallisierung bestimmt.

Bei der Abscheidung der Basisanschlußkontakte 14 wird gleichermaßen eine ebensolche zusätzliche Metallisierungsschicht auf dem Emitteranschlußkontakt 13 abgeschieden.

Anschließend erfolgt gemäß der Fig. 2H die ganzflächige Passivierung der Struktur mit einer Passivierungsschicht 15, die beispielsweise aus SiN bestehen kann und eine Dicke von 300 nm aufweisen kann. Durch eine Photolackmaske oder durch eine Spacer-Technik kann das SiN dann wieder so entfernt werden, daß die Halbleiteroberflächen geöffnet werden, die für die folgende Basis-Ätzung notwendig sind. Der Bereich zwischen Emitter und Basis-Metall muß jedoch mit SiN vor den nun folgenden Prozessen geschützt werden.

Nach der Entfernung der Lackmaske mit NMP kann dann direkt gemäß der Fig. 2I die Basis-Ätzung durchgeführt werden. Dabei kann prinzipiell genauso vorgegangen werden wie bei der Emitter-Ätzung. Die noch vorhandene Restschicht der InGaP-Emitterschicht 5 wird zunächst mit hoher Leistung entfernt. Im zweiten Schritt wird mit geringerer Leistung das GaAs-Material der Kollektorschicht 3 geätzt. Mittels einer zwischen der Kollektorschicht 3 und der Subkollektorschicht 2 vorhandenen AlGaAs-Ätzstoppschicht kann die Ätzung sehr homogen auf dem Wafer gestoppt werden.

Vor der Kollektor-Metallisierung wird zunächst die nur 20 nm dünne AlGaAs-Ätzstoppschicht in einem Ar-Sputter-Schritt entfernt. Dann werden Kollektoranschlußkontakte 16, vorzugsweise bestehend aus der Schichtenfolge Ge/Au/Ni/Au beidseits der mesaförmigen Strukturen aufgebracht. Das Einlegieren der Basis- und Kollektoranschlußkontakte kann dann in einem Prozeßschritt erfolgen.

Vor dem Aufbringen der Kollektoranschlußkontakte 16 wird demgemäß in dem erfindungsgemäßen Ausführungsbeispiel entsprechend der Fig. 2I eine zweite mesaförmige Struktur durch Strukturieren der Basisschicht 4 und der Kollektorschicht 3 geformt. Dies ist jedoch im Sinne der Erfindung nicht zwingend erforderlich. Es können alternativ auch eine oder mehrere Kontaktlochätzungen durch die Basisschicht 4 zu der Kollektorschicht 3 oder durch die Basisschicht 4 und die Kollektorschicht 3 bis zu der Subkollektorschicht 2 durchgeführt werden, um anschließend die Kontaktlöcher mit elektrisch leitfähigem Material zu füllen und somit die Kollektor-Metallisierung zu bilden.

Anschließend wird gemäß Fig. 2K eine Ätzmaskenschicht 17 aus SiN für den Zweck der Isolierung der Bauelemente voneinander aufgebracht. Die Ätzmaskenschicht 17 wird so strukturiert, daß sie mit dem Außenrand der Kollektoranschlußkontakte 16 abschließt. Bei der Isolationsätzung wird dann eine elektrische Isolation von Bauelement zu Bauelement realisiert, indem zunächst in die Subkollektorschicht 2 bis zu einer zwischen dem Substrat 1 und der Subkollektorschicht 2 angeordneten AlGaAs-Pufferschicht geätzt und anschließend wird in einem zweiten Schritt die Pufferschicht entfernt und etwa 300 nm in das Substrat 1 geätzt.

Dann wird gemäß Fig. 2L eine Planarisierungsschicht 18 aus SiN auf die isolierte Bauelementstruktur aufgebracht. Diese Planarisierungsschicht 18 wird vorzugsweise in drei Prozeßschritten aus drei Schichten mit Dicken von jeweils 300, 200 und 300 nm aufgewachsen.

Um die Emitter mehrerer Transistoren anschließend in an sich bekannter Weise mit einer sogenannten Luftbrücke verbinden zu können, wird gemäß der Fig. 2M mit einer Photolackmaske die Emitter-Metallisierung durch einen trockenchemischen Ätzschritt geöffnet. In diese wird dann gemäß der Fig. 2N eine Luftbrücken-Metallisierung 19 durch einen galvanischen Prozeß eingebracht, um die Emitter der Transistoren mit Hilfe einer Standard-Luftbrückentechnik miteinander zu verbinden.

## Patentansprüche

1. Verfahren zur Herstellung eines Heterobipolar-Transistors, mit den Verfahrensschritten:
A.) Aufwachsen einer Folge von Epitaxieschichten enthaltend eine Kollektorschicht (3), eine Basisschicht (4) und eine Emitterschicht (5) auf ein Halbleitersubstrat (1);
B.) Aufwachsen einer Isolationsschicht (11) und Formen einer bis zu der Emitterschicht (5) reichenden Emitteröffnung in die Isolationsschicht (11);
C.) Abscheiden eines Emitteranschlußkontaktes (12, 13) in die Emitteröffnung derart, daß dieser sich mindestens entlang einem Umfangsabschnitt der Emitteröffnung über den Öffnungsrand hinaus auf die Oberfläche der Isolationsschicht (11) erstreckt;
D.) Erzeugen einer mesaförmigen Struktur durch Entfernen der Isolationsschicht (11) und mindestens teilweises Entfernen der Emitterschicht (5) außerhalb des Emitteranschlußkontaktes (12, 13) durch einen oder mehrere Ätzschritte mit dem Emitteranschlußkontakt (12, 13) als Ätzmaske;
E.) Abscheiden mindestens eines Basisanschlußkontaktes (14) auf einem Abschnitt außerhalb der mesaförmigen Struktur;
F.) mindestens auf einem Abschnitt Entfernen von gegebenenfalls einem verbliebenen Teil der Emitterschicht (5) und der Basisschicht (4) außerhalb der mesaförmigen Struktur;
G.) Abscheiden mindestens eines Kollektoranschlußkontaktes (16) auf dem nicht mehr von der Basisschicht (4) bedeckten Abschnitt.

2. Verfahren nach Anspruch 1,
**dadurch gekennzeichnet, daß**
- nach Aufwachsen der Emitterschicht (5) im Verfahrensschritt A. eine Emitterkontaktschicht (6a, 6b) aufgewachsen wird und anschließend auf die Emitterkontaktschicht (6a, 6b) im Verfahrensschritt B. die Isolationsschicht (11) aufgewachsen wird.

3. Verfahren nach Anspruch 1 oder 2,
**dadurch gekennzeichnet, daß**
- die Isolationsschicht (11) im Verfahrensschritt B. eine SiN-Schicht ist.

4. Verfahren nach einem der vorhergehenden Ansprüche,
**dadurch gekennzeichnet, daß**
- der Emitteranschlußkontakt (12, 13) eine erste Kontaktschicht (12), vorzugsweise bestehend aus einer WSi-Schicht oder einer W/WSi-Schichtenfolge, und eine zweite Kontaktschicht (13), vorzugsweise aus einer Ti/Pt/Au-Schichtenfolge aufweist.

5. Verfahren nach Anspruch 4,
**dadurch gekennzeichnet, daß**
- im Verfahrensschritt C. zuerst die erste Kontaktschicht (12) ganzflächig abgeschieden wird,
- anschließend die zweite Kontaktschicht (13) vorzugsweise mittels der Image-Reversal-Phototechnik in die Emitteröffnung und den Randbereich abgeschieden wird, und
- anschließend die erste Kontaktschicht (12) außerhalb der zweiten Kontaktschicht (13) entfernt wird, wobei die zweite Kontaktschicht (13) als Maske verwendet wird.

6. Verfahren nach Anspruch 5,
**dadurch gekennzeichnet, daß**
- das Entfernen der ersten Kontaktschicht (12) im Verfahrensschritt C. und das Entfernen der Isolationsschicht (11) im Verfahrensschritt D. unmittelbar aufeinanderfolgend in einem einzigen Ätzschritt durchgeführt werden.

7. Verfahren nach Anspruch 2,
**dadurch gekennzeichnet, daß**
- nach dem Entfernen der Isolationsschicht (11) die Emitterkontaktschicht (6a, 6b) entfernt wird.

8. Verfahren nach einem der vorhergehenden Ansprüche,
**dadurch gekennzeichnet, daß**
- die Emitterschicht (5) im Verfahrensschritt D. durch Sputtern, beispielsweise mit Ar, abgetragen wird.

9. Heterobipolar-Transistor mit
- einer Folge von Epitaxieschichten enthaltend eine Kollektorschicht (3), eine Basisschicht (4), eine Emitterschicht (5) und einen Emitteranschlußkontakt (12, 13), wobei
- der Emitteranschlußkontakt (12, 13) Teil einer mesaförmigen Struktur ist,
**dadurch gekennzeichnet, daß**
- zwischen dem Emitteranschlußkontakt (12, 13) und der Emitterschicht (5) eine mindestens entlang einem Umfangsabschnitt der mesaförmigen Struktur verlaufende elektrisch isolierende Zone (lla) geformt ist.

10. Heterobipolar-Transistor nach Anspruch 9,
**dadurch gekennzeichnet, daß**
- der Emitteranschlußkontakt (12, 13) einen der Emitterschicht (5) zugewandten Abschnitt aufweist, der von der elektrisch isolierenden Zone (11a) umgeben ist.

11. Heterobipolar-Transistor nach Anspruch 9 oder 10,
**dadurch gekennzeichnet, daß**
- die elektrisch isolierende Zone (11a) SiN enthält oder daraus gebildet ist.

12. Heterobipolar-Transistor nach einem der vorhergehenden Ansprüche,
**dadurch gekennzeichnet, daß**
- zwischen dem Emitteranschlußkontakt (12, 13) und der Emitterschicht (5) eine Emitterkontaktschicht (6a, 6b) angeordnet ist.
